**Europäisches Patentamt**

**European Patent Office**

**Office européen des brevets**

(19)

(11) Veröffentlichungsnummer : **0 068 493**
**B1**

(12) **EUROPÄISCHE PATENTSCHRIFT**

(45) Veröffentlichungstag der Patentschrift :
01.10.86

(21) Anmeldenummer : 82105760.1

(22) Anmeldetag : 29.06.82

(51) Int. Cl.⁴ : **G 01 R   1/073**

(54) **Kontaktsonden-Anordnung für integrierte Schaltungselemente.**

(30) Priorität : 30.06.81 US 278950
30.06.81 US 279128

(43) Veröffentlichungstag der Anmeldung :
05.01.83 Patentblatt 83/01

(45) Bekanntmachung des Hinweises auf die Patenterteilung : 01.10.86 Patentblatt 86/40

(84) Benannte Vertragsstaaten :
DE FR GB IT

(56) Entgegenhaltungen :
IBM TECHNICAL DISCLOSURE BULLETIN, Band 16, Nr. 5, Oktober 1973, Seiten 1606-1607, New York (USA); A.W.CUMMINS et al.: "Fabrication of a cast epoxy guide"
IBM TECHNICAL DISCLOSURE BULLETIN, Band 17, Nr. 2, Juli 1974, Seiten 638-639, New York (USA); S.I.BRUDER et al.: "Dual buckling beam connectors for test probes"
IBM TECHNICAL DISCLOSURE BULLETIN, Band 12, Nr. 4, September 1969, Seite 551, New York (USA); A.W.TILL: "Column contact probe"
IBM TECHNICAL DISCLOSURE BULLETIN, Band 16, Nr. 5, Oktober 1973, Seite 1366, New York (USA); S.I.BRUDER et al.: "Buckling beam probe"

(73) Patentinhaber : **International Business Machines Corporation**
**Old Orchard Road**
**Armonk, N.Y. 10504 (US)**

(72) Erfinder : **Coughlin, Charles Paul**
**Spring Street**
**Chelsea New York 12512 (US)**
Erfinder : **Faure, Louis Henry**
**24 King Drive**
**Poughkeepsie New York 12603 (US)**
Erfinder : **Townsend, Dana Roberts**
**R.D. No.3, Box 151 Osbourne Hill**
**Fishkill New York 12524 (US)**
Erfinder : **Walsh, Thomas Joseph**
**2 Deer Run Road**
**Poughkeepsie New York 12603 (US)**

(74) Vertreter : **Brügel, Gerhard, Dipl.-Ing.**
**Schönaicher Strasse 220**
**D-7030 Böblingen (DE)**

**Beschreibung**

Die Erfindung betrifft eine Kontaktsonden-Anordnung zur zeitweiligen elektrischen Verbindung einer Testeinrichtung mit einem integrierten Schaltungselement, mit einer Mehrzahl paralleler, in Löchern einer oberen und einer unteren rechteckigen plattenförmigen Führungsrahmeneinheit unter der Wirkung axialer Druckkräfte auslenkbarer Kontaktsonden zum Aufsetzen auf die Kontaktpunkte der Schaltungselemente unter Federkraft, und mit einem zwischen den Führungsrahmeneinheiten angeordneten, diese verbindenden Verbindungsteil.

Kontaktsonden dieser Art sind ein wesentlicher Bestandteil der Prüfeinrichtungen für die Qualität und Funktion von Halbleiterchips, bevor diese auf einem Keramikplättchen, dem sogenannten Substrat, befestigt werden und so einen elektrischen Baustein oder Modul bilden. Diese Chips enthalten eine große Anzahl von in Miniaturtechnik hergestellten integrierten Bauelementen, z. B. Transistoren, Dioden und/oder Widerstände, sowie komplette Schaltungsanordnungen und bestehen aus kleinen Halbleiterplättchen in der Abmessung von beispielsweise 5 × 5 mm. An der Unterseite der Chips sind eine Anzahl Kontaktpunkte vorgesehen, die mit den im Chip enthaltenen Schaltkreisen verbunden sind. Da die Unterseite der Chips eine relativ kleine Fläche bildet und eine große Anzahl von Kontaktpunkten vorgesehen werden muß, ergibt sich eine entsprechend große Pakkungsdichte für die Chipanschlüsse. Diese Chips werden auf Keramikplättchen aufgesetzt, die mit Leiterbahnen versehen sind, und die Kontaktpunkte der Chips werden beispielsweise durch ein Lötschmelzverfahren mit den Leiterbahnen der Trägerplättchen verbunden. Mehrere Chips bilden hierbei ein Matrixmuster, z. B. in der Anordnung 3 × 3 oder 10 × 10, so daß auch die Kontaktpunkte in einer regelmäßigen Verteilung auf der Oberfläche der Substrate angeordnet sind.

Wegen der großen Zahl von Kontaktpunkten und ihrer sehr geringen Abstände voneinander benötigt man Kontaktsonden, um die Verbindung zwischen der integrierten Schaltung und der Testeinrichtung herzustellen, mittels derer die elektrischen Funktionen der Schaltung geprüft werden. Diese Kontaktsonden sind mit einer räumlichen Transformationseinrichtung kombiniert, die den Übergang zwischen den sehr dicht aneinanderliegenden Kontaktpunkten der Schaltung und den zugeordneten Anschlußpunkten des Testgeräts herstellt. Eine Ausführung einer solchen räumlichen Transformationseinrichtung ist beispielsweise in der US-A-3 911 361 beschrieben.

Zusätzlich zu den Problemen, welche die hohe Dichte der Kontaktpunkte bereitet, ergeben sich auch mechanische Schwierigkeiten bei der Kontaktgabe zwischen der Transformationseinrichtung und den Substraten. So werden die keramischen Mehrschichtlaminate bei der Herstellung Temperaturen bis zu 1 500 °C ausgesetzt, wodurch die Werkstoffe eine gewisse Schrumpfung erfahren, mit der Folge von Unregelmäßigkeiten in den Abmessungen, z. B. auch hinsichtlich der Kontaktpunktabstände. Hierdurch wird die Genauigkeit beim Aufsetzen der Sonden auf die Kontaktpunkte in Mitleidenschaft gezogen.

Die hohen Behandlungstemperaturen bewirken aber auch gewisse Unregelmäßigkeiten in der Höhe der Kontaktpunkte. Werden die Kontaktsonden nicht mit ausreichend bemessener Kraft aufgesetzt, so kann es vorkommen, daß zwischen den am tiefsten liegenden Kontaktpunkten und den zugehörigen Sonden kein Kontakt oder kein ausreichender Kontakt zustandekommt. Wird dagegen, um dies zu verhindern, die Aufsetzkraft der Kontaktsonden entsprechend groß gewählt, kann es vorkommen, daß die Kontaktpunkte oder sogar das ganze Chip beschädigt werden.

Zur Lösung dieser Probleme wurde bereits vorgeschlagen, elastisch biegsame Kontaktsonden zu verwenden, die zwischen zwei Ausrichtplatten angeordnet und in der unteren Ausrichtplatte längsverschiebbar geführt sind, derart, daß bei axial wirksamer Druckkraft die Kontaktsonden in eine bestimmte, vorgegebene Richtung ausgelenkt werden. Dadurch wird erreicht, daß die auf die Kontaktpunkte wirksamen Kräfte einheitlich sind, auch wenn die Kontaktpunkte unterschiedliche Höhe aufweisen. Denn die unterschiedlichen Höhen der einzelnen Punkte werden durch eine entsprechend unterschiedliche Auslenkung der Kontaktsonden ausgeglichen. Außerdem haben die Auslenkungen der Kontaktsonden zur Folge, daß die Auflagefläche größer ist, als wenn nur ein Punktkontakt stattfindet, wodurch Positionsabweichungen der Kontaktpunkte in gewissem Umfang ausgeglichen werden.

Bei dieser, in der US-A-3 806 801 beschriebenen Anordnung, sind die einzelnen Kontaktsonden mit isolierenden Überzügen versehen, damit beim Auslenken der einzelnen Sondenelemente kein elektrischer Kontakt zwischen ihnen entstehen kann. Zur Steuerung der Auslenkung sind entweder die Öffnungen in der oberen und der unteren Ausrichtplatte zumindest in einer Richtung zueinander versetzt angeordnet, oder die Öffnungen in der oberen Ausrichtplatte weisen einen bestimmten Winkel zu der Axialrichtung auf und bestimmen dadurch die Auslenkrichtung, oder beide Maßnahmen werden kombiniert angewendet.

Auch dieser Ausführung haften jedoch gewisse Nachteile an. So erfordert die Herstellung der Ausrichtplatten ein hohes Maß an Präzision, insbesondere, wenn beide vorerwähnten Maßnahmen angewendet, also die Öffnungen der Ausrichtplatten gegeneinander versetzt und die Öffnungen der oberen Ausrichtplatte schräg ausgerichtet sind. Außerdem sind die Tastsonden hier in einer Reihe angeordnet, so daß bei hochintegrierten Schaltungselementen die Sonden relativ zum Substrat sehr häufig von einem zum anderen Chipbereich bewegt werden müssen, was sich ungünstig auf die Testgeschwindigkeit auswirkt. So sind z. B. für eine 10 × 10 Chip-Anordnung Sondengruppen von jeweils zwei Reihen, also mit 20 gebündelten Sonden erforderlich, eine Anforderung, die mit der bekannten Ausführung nicht erfüllt werden kann.

Schließlich vermag die Schräganordnung der Tastsonden wegen der hohen Anforderungen an die Genauigkeit der Ausrichtung zu den Kontaktpunkten keine einheitliche Auslenkung zu gewährleisten, wenn eine einheitliche Axialkraft angewendet wird. Denn die tatsächliche Auslenkrichtung kann dennoch variieren, so daß die Gefahr von Kontakten zwischen den einzelnen Sonden besteht, weshalb bei der bekannten Ausführung auch isolierende Überzüge notwendig sind.

Für Testvorgänge der hier beschriebenen Art sind weiterhin Tastsonden-Anordnungen bekannt, wie in der US-A-3 906 363 beschrieben, bei der eine Mehrzahl von Metallfederfingern vorgesehen sind, die Reibungskontakt mit in jeder Schaltungsplatte befindlichen Öffnungen herstellen. Eine andere Tastsonden-Anordnung (US-A-3 731 191) mit einer Mehrzahl von Kontaktsonden zum Aufsetzen auf Kontaktpunkte weist eine Mehrzahl elektrisch leitender Prüfsonden mit geringem Durchmesser und elektrisch leitenden Führungsröhrchen auf, die zu den Prüfsonden elektrische Verbindung haben. Die Prüfsonde ragt mit einem Ende aus dem Führungsröhrchen heraus, und dieses Ende dient als Kontaktspitze, wobei der Prüfdraht verschiebbar und federnd im Führungsröhrchen angeordnet ist. Dabei ist das Führungsröhrchen gebogen ausgebildet, so daß eine Federcharakteristik entsteht.

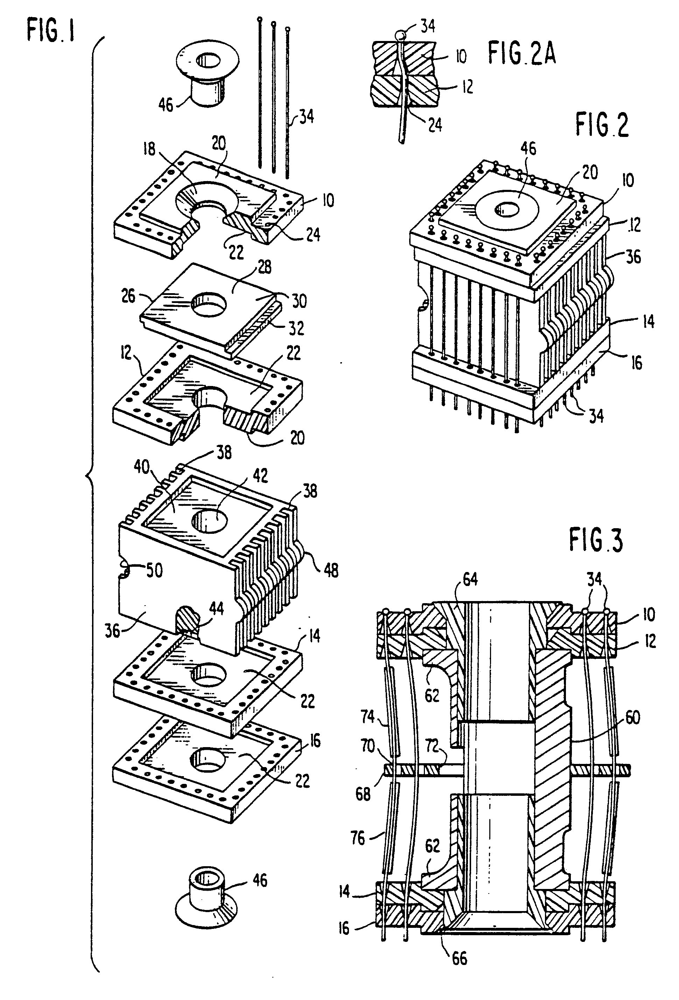

Bei einer im IBM Technical Disclosure Bulletin (TDB), Band 16, Seiten 1606/07 beschriebenen Anordnung sind die einzelnen Kontaktsonden in der Mitte an einer Stelle bleibend geknickt, um bei axialer Krafteinwirkung das Auslenken in einer einheitlichen Richtung zu bewirken. Auslenkung und Auslenkrichtung sind daher allein durch diese Knickstelle vorgegeben. Bei einer weiteren bekannten Kontaktsondenanordnung (IBM TDB, Band 12, Seite 551) erfolgt die Vorauslenkung der Drähte durch einen Ansatz, mit der Wirkung einer Biegestelle im elastischen Bereich, vergleichbar mit der Ausbildung gemäß Fig. 3 der vorgenannten Literaturstelle. Weiterhin ist im IBM TDB, Band 17, Seiten 638/39 eine Anordnung gezeigt, deren Kontaktsonden im unteren Bereich frei auslenkbar und im oberen Bereich vorgebogen sind, so daß im letzteren die Auslenkrichtung hierdurch vorbestimmt ist.

Der Erfindung liegt die Aufgabe zugrunde, eine Kontaktsonden-Anordnung zu schaffen, welche bei einfachem Aufbau und wirtschaftlicher Herstellung sowie bei begrenzter maximaler Aufsetzkraft der Sonden und zuverlässiger Kontaktgabe die Möglichkeit bietet, alle Kontaktanschlüsse der vier Randbereiche eines Chips in einem Arbeitsgang zu testen, und die somit die Testzeit wesentlich verkürzt. Diese Aufgabe ist durch die im Patentanspruch 1 angegebene Ausbildung gelöst worden.

Verschiedene bevorzugte Ausführungsformen der Erfindung sind in den Ansprüchen 2 bis 10 enthalten. Dabei ist die Maßnahme nach Anspruch 6, bei einer Vorrichtung der gattungsgemäßen Art eine Führungsscheibe mit einer der Anzahl und Verteilung der Kontaktsonden entsprechenden Zahl von Löchern exzentrisch anzuordnen, um die Auslenkrichtung vorzubestimmen, durch die DE-A-31 23 627 bekannt.

Die Erfindung wird nachfolgend anhand der Zeichnungen in zwei Ausführungsbeispielen beschrieben. Es zeigen :

Figur 1　eine Kontaktsonden-Anordnung in einer ersten Ausführungsform in auseinandergezogener, schaubildlicher Darstellung,

Figur 2　die Anordnung gemäß Fig. 1 in zusammengebautem Zustand,

Figur 2A　einen vergrößerten Detailschnitt durch zwei benachbarte Führungsrahmen und eine darin geführte, ausgelenkte Kontaktsonde,

Figur 3　die Schnittdarstellung einer zweiten Ausführungsform einer Kontaktsonden-Anordnung,

Figur 4　eine vergrößerte Darstellung des unteren Teiles der Anordnung nach Fig. 3 mit zusätzlichem Führungsrahmen und

Figur 5　eine der Fig. 4 entsprechende Darstellung einer Alternativausführung.

Die in Fig. 1 dargestellte modulare Kontaktsonden-Anordnung enthält vier Führungsrahmen 10, 12, 14 und 16, die untereinander nahezu gleich und aus isolierendem Werkstoff geformt, z. B. gegossen sind. Jeder der Führungsrahmen 10 bis 16 hat eine zentrale Öffnung 18 und ist auf der einen Seite mit einem Vorsprung 20 und auf der anderen Seite mit einer entsprechenden Ausnehmung 22 versehen. Über den Umfang jedes Führungsrahmens sind eine Anzahl Löcher 24 verteilt. Die Löcher 24 sind so angeordnet, daß sie zu den EC-Kontaktpunkten (EC = Engineering Change), auf die sie aufgesetzt werden sollen, ausgerichtet sind. In dem in Fig. 1 dargestellten Beispiel ist nur eine Reihe von Löchern 24 gezeigt, es kann jedoch im Umfangsbereich der Führungsrahmen auch eine Mehrzahl von Lochreihen vorgesehen werden, wenn die entsprechenden EC-Kontaktpunkte des zugehörigen Chipbereiches in Mehrfachanordnung vorgesehen sind. Die Löcher 24 sind zum erleichterten Einführen der Kontaktsonden 34, wie Fig. 2A zeigt, kegelförmig geformt.

Wenn, wie in Fig. 1 gezeigt, der Führungsrahmen 10 mit einem Vorsprung 20 an seiner Oberseite ausgestattet ist, erhält man eine entsprechende Ausrichtung der Kontaktsonden zu der benachbarten (nicht gezeigten) räumlichen Transformationseinrichtung. Zwischen den Führungsrahmen 10 und 12 ist ein Zwischenstück 26 mit einer zentralen Öffnung 28 angeordnet, das aus zwei Flächenstücken 30 und 32 zusammengesetzt ist. Das obere Flächenstück 30 paßt in die entsprechende Ausnehmung 22 des oberen Führungsrahmens 10, während das untere Flächenstück 32 in seinen Abmessungen der Ausnehmung 22 des unteren Führungsrahmens 12 angepaßt ist. Die Führungsrahmen 10 und 12 nehmen somit in ihrer unteren bzw. oberen Ausnehmung die Flächenstücke 30 und 32 des Zwischenstücks 26 auf.

Das in Fig. 1 gezeigte Zwischenstück 26, das aus dem gleichen Material besteht wie die Führungsrahmen 10 und 12, bewirkt, da die Flächenstücke 30 und 32 gegeneinander versetzt sind, eine entsprechende Versetzung der Löcher 24 des Führungsrahmens 12 relativ zu denjenigen des Führungsrahmens 10. Werden die Kontaktsonden 34 durch die Löcher 24 im Führungsrahmen 10 und im Führungsrahmen 12 eingesteckt, so werden sie um ein gewisses Maß ausgelenkt, wie in Fig. 2A gezeigt ist. Dies wird durch die Form der Löcher 24 gemäß Fig. 2A erleichtert. Die Löcher 24 des Führungsrahmens 10 und des Führungsrahmens 12 sind somit infolge der Verwendung des Zwischenstücks 26 nicht axial zueinander ausgerichtet.

Damit, wenn eine Kraft vorbestimmter Größe axial auf die Kontaktsonden 34 wirksam wird, diese um ein gewisses erwünschtes Maß ausknicken können, sind sie aus einem hierfür geeigneten Werkstoff hergestellt, z. B. BeNi, BeCu, Wolfram oder ähnlichen Materialien. Ist beim Aufsetzen der Anordnung auf die Kontaktpunkte die auf die einzelnen Kontaktsonden wirksame Kraft erreicht, so bleibt sie im wesentlichen konstant, da hierbei die Auslenkung zwischen den Führungsrahmen stattfindet, und zwar in unterschiedlichem Ausmaß, da die Kontaktpunkte nicht genau einheitlich, sondern in gewissen Grenzen unterschiedlich hoch sein können. Die auf die Kontaktpunkte des Werkstücks wirksamen Kräfte bleiben daher auf ein vorherbestimmbares Maß begrenzt, da beim Wirksamwerden der Auflagekraft die einzelnen Kontaktsonden 34 ausgelenkt werden.

Die Festlegung der Kontaktsondenlänge erfolgt in Übereinstimmung mit den in dieser Technologie bekannten Gesetzen. Die Sonden werden nach der folgenden Gleichung gestaltet :

$$F = (3\pi)^2 \, EI/L^2$$

wobei bedeuten :

F = axiale Belastung auf das Ende der Kontaktsonde 34, die ausgelenkt wird,
E = Elastizitätsmodul des Sondenmaterials,
I = axiales Trägheitsmoment der Sonde und
L = Länge der Sonde.

Angenommen, die Kontaktsonde 34 hat kreisförmigen Querschnitt, so ist ihr axiales Trägheitsmoment definiert mit

$$I = \pi D^4/64$$

wobei D = Durchmesser der Sonde. Es können jedoch auch andere Querschnittsformen für die Kontaktsonde Verwendung finden, wie z. B. rechteckig oder quadratisch.

Aus der obigen Gleichung ist ohne weiteres erkennbar, daß die erforderliche Länge der Kontaktsonde leicht ermittelt werden kann, da E eine Funktion des Werkstoffes, D bekannt und I als Funktion des Querschnittes ableitbar ist. Daher kann durch entsprechende Wahl der Länge der Kontaktsonden eine vorherbestimmbare Kraft auf die EC-Kontaktpunkte ausgeübt werden, die nicht überschritten wird, da die Sonde andernfalls, bei Anwendung größerer Kräfte, ausgelenkt wird.

Wie Fig. 1 zeigt, befindet sich an den oberen Enden der Kontaktsonden 34 ein leitender kugelförmiger Punkt, beispielsweise als Lötpunkt, um eine zuverlässige Verbindung zwischen der Kontaktsonde und der zugeordneten räumlichen Transformationseinrichtung herzustellen.

Das in Fig. 1 dargestellte Trennstück 36 dient zur Festlegung der Gesamtanordnung und weist eine bestimmte Höhe auf, damit die Kontaktsonden 34 die erforderliche Länge zum Auslenken zur Verfügung haben. Kanäle 38 in der Außenwand des Trennstücks 36 dienen zur Führung der Kontaktsonden 34 und verhindern, daß diese zueinander in Berührung gelangen und damit elektrischen Kontakt erhalten können. Die Ausnehmung 40 an der oberen Seite des Trennstücks 36 dient zur Aufnahme der Vorsprungs des Führungsrahmens 12 an dessen Unterseite. Eine zentrale Öffnung 42 nimmt, wie später noch beschrieben wird, ein entsprechendes Verbindungselement auf. An der Unterseite des Trennstücks 36 befindet sich ein Vorsprung 44, welcher seinerseits in die Ausnehmung 22 des Führungsrahmens 14 ragt.

Die Führungsrahmen 14 und 16 sind in ihrer Lage zueinander durch das Einpassen des Vorsprungs 20 an der Unterseite des Führungsrahmens 14 in die Ausnehmung 22 an der Oberseite des Führungsrahmens 16 bestimmt. In dieser Lage sind die Löcher 24 zueinander ausgerichtet.

Die gesamte in Fig. 1 dargestellte Anordnung wird durch Hohlbolzen 46 mit Preßsitz zusammengehalten. Es können jedoch auch andere Verbindungsmittel, wie Schrauben, verwendet werden.

Die ohrförmigen Ansätze 48 am Trennstück 36 dienen dazu, die Kontaktsonden 34 zu führen und zu verhindern, daß Sonden in die Kanäle benachbarter Sonden gelangen. Außerdem dienen sie in Zusammenwirken mit den ohrförmigen Einschnitten 50 an der entgegengesetzten Seite des Trennstücks 36 zur Ausrichtung benachbarter Anordnungen.

Die in Fig. 2 zusammengebaut dargestellte Kontaktsonden-Anordnung ist an einem (nicht gezeigten) beweglichen Arm befestigt, der die Kontaktsonden 34 in Berührung mit den einzelnen Kontaktpunkten auf dem Chip (nicht dargestellt) bringt. Hierbei wird eine einheitliche Auflagekraft auf jedem Kontaktpunkt wirksam, da Unterschiede in der Höhe der einzelnen Kontaktpunkte durch das unterschiedliche Ausmaß des Auslenkens der einzelnen Kontaktsonden ausgeglichen werden. Über das vorgegebene Maximalmaß hinausgehende Auflagekräfte können somit nicht wirksam werden.

Bei der Ausführungsform nach Fig. 3 werden zwei Paare von Führungsrahmen verwendet. Der Unterschied zur Ausführungsform nach Fig. 1 besteht hierbei insbesondere darin, daß das Zwischenstück 26 entfällt. Der Führungsrahmen 10 ruht mittels der bereits vorher erwähnten Paarung von Vorsprung und Ausnehmung im Führungsrahmen 12, während der Führungsrahmen 14 in gleicher Weise im Führungsrahmen 16 fixiert ist. Beide Paare von Führungsrahmen dienen zur Ausrichtung der Kontaktsonden. Die Löcher 24 sind gleichfalls konisch gestaltet, um das Auslenken zu erleichtern. Auch hinsichtlich der Werkstoffauswahl und Längenbestimmung gelten die gleichen Erfordernisse wie im Zusammenhang mit dem Ausführungsbeispiel nach Fig. 1 beschrieben.

Eine Hülse 60 mit Ansätzen 62 an jedem Ende ist so bemessen, daß sie in die Ausnehmungen 22 jedes der benachbarten Führungsrahmen 12, 14 genau hineinpaßt. Die Führungsrahmen 10 bis 16 sind von oben und unten auf die Hülse 60 aufgesetzt und werden mittels Hohlbolzen 64 und 66 mit Preßsitz zusammengehalten. Auch hier können jedoch andere Verbindungsmittel, wie z. B. eine Schraube, eingesetzt werden, mittels deren die beiden Führungsrahmenpaare fest mit der Hülse 60 verbunden werden.

Anstelle des Trennstücks 36 nach Fig. 1 dient hier die Hülse 60 als Distanzelement, und im Mittelbereich ist eine Führungsscheibe 68 « fliegend » angeordnet, was sowohl die Vorauslenkung der Kontaktsonden als auch deren gegenseitige Isolierung bewirkt. Die Führungsscheibe 68 ist zu diesem Zweck mit entsprechenden Reihen von Löchern 70 versehen, die hinsichtlich ihrer Anzahl und Verteilung an die entsprechenden Löcher in den Führungsrahmen 10 bis 16 angepaßt sind, und, wie Fig. 3 zeigt, mittels einer asymmetrischen Mittelöffnung 72 asymmetrisch zur Hülse 60 angeordnet. Die Löcher 70 in der Führungsscheibe 68 sind, wie Fig. 3 weiter zeigt, wesentlich größer als die Löcher 24 in den Führungsrahmen, damit die Kontaktsonden 34 ungehindert axial bewegt werden können.

Distanzröhrchen 74, 76 sind über die Kontaktsonden 34 geschoben und sichern, daß die Führungsscheibe 68 bei der Axialbewegung der Kontaktsonden nicht vertikal verschoben wird.

Die untere Fläche des Führungsrahmens 16 bei der Ausführungsform nach Fig. 3 bildet, ebenso wie die entsprechende Fläche des Führungsrahmens 16 nach Fig. 1, eine Anschlagfläche und kann in geeigneter Weise mit einer Beschichtung versehen sein, um die Oberfläche des zu testenden Werkstücks beim Aufsetzen nicht zu beschädigen.

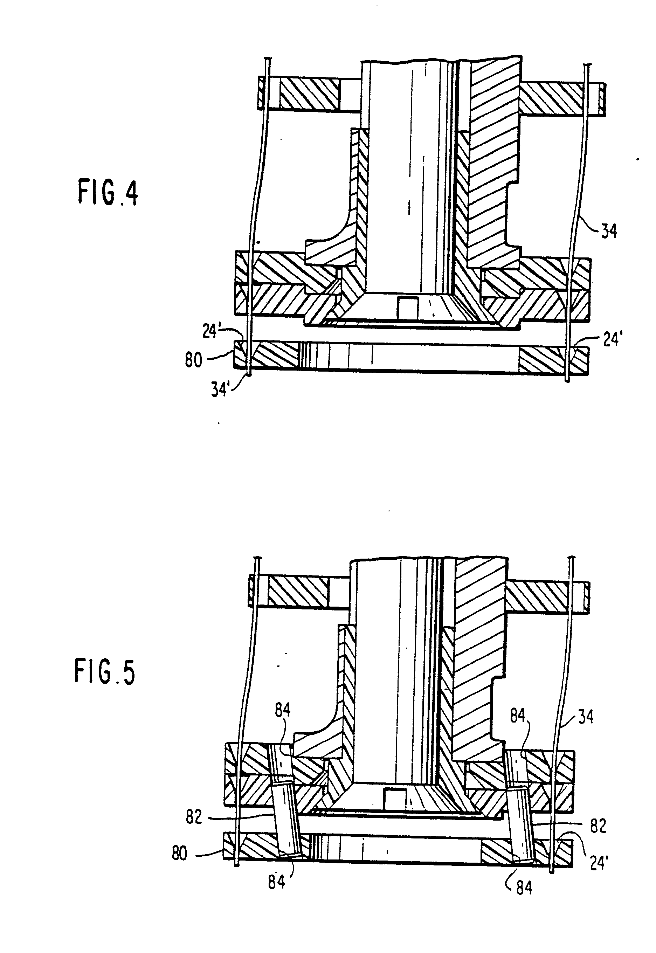

Bei der Ausführungsform nach Fig. 4 ist unterhalb des Führungsrahmens 16 ein weiterer Führungsrahmen 80 angeordnet, um auf diese Weise die Länge der überstehenden Enden 34' der Kontaktsonden 34 zu verkürzen und damit die Gefahr einer Beschädigung derselben zu verringern. Der Führungsrahmen 80 kann entweder mechanisch mit dem Führungsrahmen 16 verbunden sein oder, wie in Fig. 4 gezeigt, als flache Platte ausgebildet werden, durch deren Löcher 24' die Kontaktsonden unverschiebbar geführt sind.

Eine andere Art der Verbindung zwischen den Führungsrahmen 14, 16 und dem Führungsrahmen 80 zeigt Fig. 5. Hier sind Führungsstifte 82 unter einem geringen Winkel gegen die Axialrichtung vorgesehen, z. B. in der Größenordnung von 6°. Die unteren Enden der Kontaktsonden sind auf diese Weise um einen einheitlichen Winkel abgelenkt, um den erwünschten Schrägauflageeffekt an den Kontaktpunkten zu erzielen. Die Führungsstifte 82 sind durch entsprechende Bohrungen 84 in den Führungsrahmen 14 und 16 sowie im Führungsrahmen 80 eingeführt, wobei sie im letzteren mittels Preßsitz befestigt sind, während sie in den beiden oberen Führungsrahmen 14 und 16 längsbeweglich geführt sind. Auch bei einer solchen Ausbildung werden somit, zusätzlich zu der Auslenkung der Kontaktsonden 34 im Bereich der Führungsscheibe 68, die unteren Enden der Kontaktsonden 34 in dem gewünschten Sinne abgelenkt.

**Pantentansprüche**

1. Kontaktsonden-Anordnung zur zeitweiligen elektrischen Verbindung einer Testeinrichtung mit einem integrierten Schaltungselement, mit einer Mehrzahl paralleler, in Löchern einer oberen (10, 12) und einer unteren (14, 16) rechteckigen plattenförmigen Führungsrahmeneinheit geführter, in dem Bereich zwischen den Führungsrahmeneinheiten unter der Wirkung axialer Druckkräfte auslenkbarer Kontaktsonden (34) zum Aufsetzen auf die Kontaktpunkte der Schaltungselemente unter Federkraft, und mit einem zwischen den Führungsrahmeneinheiten angeordneten, diese verbindenden Verbindungsteil (36), dadurch gekennzeichnet, daß die Kontaktsonden (34) in mindestens einem der Führungsrahmeneinheiten (10, 12 ; 14, 16) zur Vorbestimmung ihrer Auslenkrichtung von ihrer Längsachse abweichend geführt sind.

2. Anordnung nach Anspruch 1, dadurch gekennzeichnet, daß die Führungsrahmeneinheiten aus je zwei gleichen Führungsrahmen (10, 12 ; 14, 16) bestehen, zwischen die jeweils ein Zwischenstück (26) mit zwei zueinander versetzten, in entsprechende Ausnehmungen (22) der Führungsrahmen (10, 12) einsetzbaren Flächenstücken (30, 32) einschiebbar ist, daß zur Vorbestimmung der Auslenkrichtung eine Versetzung in der Ausrichtung der Löcher (24) der Führungsrahmen (10, 12) bewirkt.

3. Anordnung nach den Ansprüchen 1 und 2, dadurch gekennzeichnet, daß die Löcher (24) in den Führungsrahmen (10, 12 ; 14, 16) konisch ausgebildet sind.

4. Anordnung nach den Ansprüchen 1 bis 3, dadurch gekennzeichnet, daß das Verbindungsteil (36) eine entsprechende Anzahl nutenförmiger Kanäle (38) zur Aufnahme der Kontaktsonden (34) aufweist.

5. Anordnung nach Anspruch 4, dadurch gekennzeichnet, daß das Verbindungsteil (36) auf einer Seite zwischen den Kanälen (38) verlaufende Ansätze (48) und au der entgegengesetzten Seite zu den Ansätzen (48) korrespondierende Einschnitte (50) aufweist.

6. Anordnung nach Anpruch 1, dadurch gekennzeichnet, daß das Verbindungsteil als Hülse (60) ausgebildet ist, auf deren Umfang eine Führungsscheibe (68) mit einer der Anzahl und Verteilung der Kontaktsonden (34) entsprechenden Zahl von Löchern (70) zur Vorbestimmung der Auslenkrichtung exzentrisch geführt angeordnet ist.

7. Anordnung nach Anspruch 6, dadurch gekennzeichnet, daß die Führungsscheibe (68) gleitend auf der Hülse (60) geführt ist und die Kontaktsonden (34) in dem Bereich zwischen Führungsscheibe (68) und den ihnen zugewandten Führungsrahmen (12, 14) mit Distanzröhrchen (74, 76) versehen sind.

8. Anordnung nach den Ansprüchen 6 und 7, dadurch gekennzeichnet, daß die Löcher (70) in der Führungsscheibe (68) einen wesentlich größeren Durchmesser aufweisen als die Löcher (24) in den Führungsrahmen (10, 12 ; 14, 16).

9. Anordnung nach den Ansprüchen 1 bis 8, dadurch gekennzeichnet, daß die Enden der Kontaktsonden (34) in einem an sich frei beweglichen weiteren Führungsrahmen (80) befestigt sind.

10. Anordnung nach Anspruch 9, dadurch gekennzeichnet, daß der weitere Führungsrahmen (80) mittels in unter einem geringen Winkel gegen die axiale Richtung ausgerichteter Bohrungen (84) befindlicher Führungsstifte (82) versetzt zu den Führungsrahmen (14, 16) geführt ist.

**Claims**

1. Contact probe array for the temporary electric connection of a test device with an integrated circuit element, comprising a plurality of parallel contact probes (34) guided in the holes of an upper (10, 12) and a lower (14, 16) rectangular plate-shaped guide frame unit and deflectable in the area between the guide frame units under the influence of axial pressure forces, for deposition onto the contact points of the circuit elements under spring force, and with a connecting part (36) arranged between the guide frame units and connecting them, characterized in that the contact probes (34) are guided in deviation from their longitudinal axis in at least one of the guide frame units (10, 12 ; 14, 16) in order to predetermine their deflecting direction.

2. Arrangement as claimed in claim 1, characterized in that the guide frame units consist of two respective equal guide frames (10, 12 ; 14, 16) between which one respective interposer (26) comprising two staggered planar elements (30, 32) insertable into corresponding recesses (22) of the guide frames (10, 12) can be introduced which for predetermining the deflecting direction effects a shift in the alignment of the holes (24) of the guide frames (10, 12).

3. Arrangement as claimed in claims 1 and 2, characterized in that the holes (24) in the guide frames (10, 12 ; 14, 16) are of conical design.

4. Arrangement as claimed in claims 1 to 3, characterized in that the connecting part (36) comprises a corresponding number of groove-shaped channels (38) to hold the contact probes (34).

5. Arrangement as claimed in claim 4, characterized in that the connecting part (36) comprises on one side extensions (48) between the channels (38) and on the opposite side cavities (50) corresponding to the extensions (48).

6. Arrangement as claimed in claim 1, characterized in that the connecting part is designed as a sleeve (60) whose circumference is provided with an eccentrically guided disk (68) with a number of holes (70) corresponding to the number and distribution of contact probes (34) in order to predetermine the deflecting direction.

7. Arrangement as claimed in claim 6, characterized in that the guide disk (68) slides on the sleeve (60), and that in the area between guide disk (68) and the guide frames (12, 14) facing them the contact probes (34) are equipped with stand-off tubes (74, 76).

8. Arrangement as claimed in claims 6 and 7, characterized in that the holes (70) in the guide disk (68) have a much greater diameter than the holes (24) in the guide frames (10, 12 ; 14, 16).

9. Arrangement as claimed in any one of claims 1 to 8, characterized of that the ends of the contact probe (34) are affixed to another and freely movable guide frame (80).

10. Arrangement as claimed in claim 9, characterized in that the additional guide frame (80) is guided in a shifted mode to the guide frames (14, 16) by means of guide pins (82) in borings (84) aligned at a small angle relative to the actual direction.

**Revendications**

1. Dispositif à sondes de contact destiné à établir une liaison électrique temporaire entre un dispositif de contrôle et un élément de circuit intégré, comprenant une pluralité de sondes de contact (34) parallèles, guidées dans des trous d'unités cadres de guidage présentant la forme d'une plaque rectangulaire supérieure (10, 12) et inférieure (14, 16), et qui peuvent fléchir dans la région comprise entre les unités cadres de guidage en réponse à l'action de forces de compression axiales, de manière à s'appuyer sur les points de contact des éléments de circuits avec une force élastique, et un élément de liaison (36), disposé entre les unités cadres de guidage et qui relie ces unités, caractérisé en ce que, dans au moins une des unités cadres de guidage (10, 12 ; 14, 16) les sondes de contact (34) sont guidées dans une direction qui s'écarte de leur axe longitudinal, pour fixer à l'avance la direction de leur flexion.

2. Dispositif selon la revendication 1, caractérisé en ce que les unités cadres de guidage sont composées chacune de deux cadres de guidage identiques (10, 12 ; 14, 16) entre lesquels peut être emboîtée une pièce intercalaire (26) qui comprend deux parties plates (30, 32) décalées l'une par rapport à l'autre et qui s'encastrent dans des évidements correspondants (32) des cadres de guidage (10, 12), de manière à déterminer un décalage de l'alignement des trous (24) des cadres de guidage (10, 12) servant à prédéterminer la direction de la flexion.

3. Dispositif selon les revendications 1 et 2, caractérisé en ce que les trous (24) ménagés dans les cadres de guidage (10, 12 ; 14, 16) sont de configuration conique.

4. Dispositif selon les revendications 1 à 3, caractérisé en ce que l'élément de liaison (36) présente un nombre approprié de canaux (38) en forme de rainure destinés à recevoir les sondes de contact (34).

5. Dispositif selon la revendication 4, caractérisé en ce que, sur un côté, l'élément de liaison (36) présente des saillies (48) qui s'étendent entre les canaux (38) tandis que, sur le côté opposé, il présente des encoches (50) qui correspondent aux saillies (48).

6. Dispositif selon la revendication 1, caractérisé en ce que l'élément de liaison est constitué par une douille (60) sur la périphérie de laquelle est montée, guidée excentriquement, une plaque de guidage (68) qui présente un nombre de trous (70) correspondant au nombre et à la répartition des sondes de contact (34), ces trous servant à prédéterminer la direction de la flexion.

7. Dispositif selon la revendication 6, caractérisé en ce que la plaque de guidage (68) est guidée de façon à glisser sur la douille (60) et en ce que les sondes de contact (34) sont munies de petits tubes entretoises (74, 76) dans la région comprise entre la plaque de guidage (68) et les cadres de guidage (12, 14) qui regardent cette plaque.

8. Dispositif selon les revendications 6 et 7, caractérisé en ce que les trous (70) de la plaque de guidage (68) possèdent un beaucoup plus grand diamètre que les trous (24) des cadres de guidage (10, 12 ; 14, 16).

9. Dispositif selon les revendications 1 à 8, caractérisé en ce que les extrémités des sondes de contact (34) sont fixées à un cadre de guidage supplémentaire (80) librement mobile.

10. Dispositif selon la revendication 9, caractérisé en ce que le cadre de guidage supplémentaire (80) est guidé dans une position décalée par rapport aux cadres de guidage (14, 16) à l'aide de goujons de guidage (82) montés dans des perçages (84) qui sont inclinés d'un petit angle sur la direction axiale.

FIG.1

FIG.2A

FIG.2

FIG.3

FIG.4

FIG.5